# EUROPEAN PATENT SPECIFICATION

(11) **EP 3 462 472 B1**
(45) Date of publication and mention of the grant of the patent: **20.04.2022**
(21) Application number: 17398004.6
(22) Date of filing: 29.09.2017
(51) Int. Cl.: H01H 50/02, B60R 16/023, H01H 50/04, H05K 5/00

(54) **SEAL HOUSING FOR AN ELECTRICAL DEVICE AND SEALED RELAY USING THE SEAL HOUSING**
DICHTUNGSGEHÄUSE FÜR EINE ELEKTRISCHE VORRICHTUNG UND GEDICHTETES RELAIS MIT VERWENDUNG DES DICHTUNGSGEHÄUSES
BOÎTIER D'ÉTANCHÉITÉ POUR UN DISPOSITIF ÉLECTRIQUE ET RELAIS SCELLÉ UTILISANT LE BOÎTIER D'ÉTANCHÉITÉ

(43) Date of publication of application: 03.04.2019
(73) Proprietor: Tyco Electronics Componentes Electromecânicos Lda, 7002-552 Evora (PT)
(72) Inventor: Sandoval, Luís, 7005 Évora (PT); Leal, Nuno, Villa Nova de Gaia 4430-076 (PT)
(74) Representative: Grünecker Patent- und Rechtsanwälte PartG mbB

(56) References cited:
- CN-A- 105 845 507
- JP-A- H10 256 751
- US-A- 5 814 765
- US-A1- 2017 163 015

## Description

### TECHNICAL FIELD OF THE INVENTION

The present invention relates generally to a seal housing for an electrical device and a sealed electrical device, such as an electromagnetic relay or the like, using the seal housing for protecting the components of the electrical device against the effects of fluids, such as water and dew condensate, and more particularly, to a seal housing having a sealing base which protects any terminals of the electrical device that protrude from the base against short-circuits caused by dew condensate and for all mounting orientations of the sealed electrical device.

### BACKGROUND OF THE INVENTION

Electrical devices, such as electromagnetic relays, with sealed, fluid-tight housings for protecting the electrical device components against the penetration of fluids, moisture and/or dew condensate, are frequently employed in applications where water condensate or icing is likely to occur. For instance, such a situation may occur when the electrical device is mounted in areas where temperature may drop abruptly, such as below air conditioning systems of automobile vehicles.

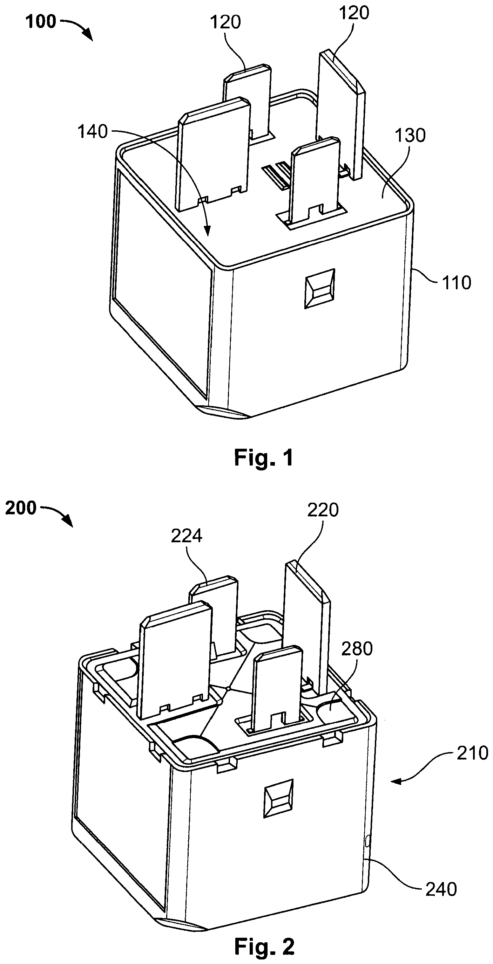

Fig. 1 depicts an exemplary configuration of such a conventional sealed relay 100. The relay assembly components (not shown) are accommodated inside a housing 110 from which electrical terminals 120 of the relay 100 protrude through a flat base 130 of the relay 100. The penetration of fluids, moisture or dust into the sealed relay 110 through the base 130 is prevented by a sealing glue 140 that is applied over the entire surface of the relay base 130. This configuration of the sealed relay 100 effectively avoids that external fluids or moisture penetrate inside the relay housing. However, this conventional configuration still has the shortcoming that external fluids or moisture at the relay base 130 may establish short-circuit paths between the relay terminals 130 and, therefore, lead to defective operation of the sealed relay 100. In particular, the risk of short-circuits forming between the relay terminals 130 increases substantially if the sealed relay 100 is mounted in an orientation that facilitates the accumulation of fluid or dew condensate between terminals 120, such as when the sealed relay 100 is mounted with the base 130 and terminals 120 facing upwards (i.e. in the direction opposed to gravity) as illustrated in Fig. 1. Another disadvantage of the sealed relay 100 shown in Fig. 1 is that it requires a significant amount of sealing glue 140, which leads to increased production costs.

Other solutions for reducing the possibility of defective operation caused by condensation or penetration of fluids into the relay housing have been put forward. For instance, published patent application JP 2002/245916 A describes an open type electromagnetic relay in which the relay contacts are provided within a contact chamber that is covered by a cover, the contact chamber and the cover being sealed by a resin tubular body formed with two parts for preventing or suppressing the invasion of moisture into the contact chamber.

Publication CN 203367153 U describes a waterproof-type automotive relay in which an upper cover and lower cover of the waterproof-type automotive relay are connected in a sealing manner by a waterproof heat-conducting glue for improving the sealing function against dust and water as well as the conduction of the heat dissipated by the relay assembly.

Patent US 4,430,537 describes a getter for use within a sealed contact chamber and which consists of a porous getter material that acts to adsorb substances which could create resistive films on the electrical contacts.

Published patent application US 2017/163015 A relates to a water drainage structure that includes a block and a cover. The block holds an electronic component at an upper portion thereof. The cover has inner wall portions that face side wall portions of the block. The cover integrally covers the electronic component and the block from above. At least either the side wall portions and the inner wall portions have upper opposing surfaces facing the other of the side wall portions and the inner wall portions at first distances disabling a lift of water by a capillary phenomenon, and raised portions raised from lower portions of the upper opposing surfaces toward the other.

Patent US 5,814,765 describes a waterproof housing with a plug-and-socket connection for protecting electronic circuits that includes a hard plastic upper part and a hard plastic lower part. A soft plastic extruded seal is disposed between the upper part and the lower part. A plug part is constructed in one piece with the upper or lower part. The plug part has a hard plastic inner part containing contact pins and a soft plastic sealing collar surrounding the inner part.

Published patent application CN 105845507 (A) describes a relay comprising: a housing which is provided with a substrate and a cover covering a side opening of the substrate; a coil element and a contact element, which are stored in the housing; an input terminal and an output terminal, which are respectively in electrical connection with the coil element and the contact element, and extend out of the bottom of the housing, so as to be welded on a circuit board. The relay also comprises a protection cover made of an insulating material, and the protection cover covers the bottom of the housing, and is used for sealing a gap between the substrate and the cover. Moreover, the protection cover is provided with a first jack corresponding to the output terminal, and a second jack corresponding to the input terminal. The output terminal and the input terminal respectively pass through the first jack and the second jack. The gap at the bottom of the housing is sealed by the protection cover.

Published patent application JPH10256751 (A) describes a sealing structure for an electronic component.

However, although the above configurations may effectively improve the protection of the components inside the housings against the penetration of fluids or moisture, they do not provide an effective protection of the electrical terminals outside the housing against the effects of moisture or condensation. As a consequence, the respective sealed relays cannot be mounted in any orientation without the risk of causing short-circuits between the terminals.

Accordingly, there is still the need for seal housings for electrical devices, such as electromagnetic relays, and of the respective sealed electrical devices using the seal housings that can be securely used in environments where the presence of fluids or dew condensation is likely to occur, that are cost effective and that reduce or even eliminate the risk of failure caused dew condensation or moisture between the relay terminals, irrespectively from the mounting orientation of the sealed electrical device.

### SUMMARY OF THE INVENTION

The present invention has been made in view of the shortcomings and disadvantages of the prior art, and an object thereof is to provide a cost-effective seal housing for an electrical device, such as a relay, that effectively protect the electrical device components inside the housing against the penetration of fluids while reducing or even eliminating the risk of defective operation due to short-circuits caused by dew condensate or moisture between the electrical device terminals. A further object of the present invention is to provide a sealed relay using the seal housing. A further object of the invention is to provide a sealing plate for protecting a terminal base of an electrical device and respective electrical terminals from fluid, dew condensate or moisture.

These objects are solved by the subject matter of the appended independent claims. Advantageous embodiments of the present invention are the subject matter of the appended dependent claims.

According to the present invention, it is provided a seal housing as defined in appended claim 1.

According to a further development, the outward side of the sealing plate comprises one or more faces that are inclined with respect to the outwardly facing side of the base by an inclination angle different from zero that causes fluid condensate to descend along the one or more inclined faces.

According to a further development, the one or more inclined faces are a plurality of inclined faces that form a pyramidal shape.

According to a further development, the sealing plate comprises one or more apertures for passing one or more terminals protruding outwards from the base, each of the one or more apertures of the sealing plate surrounding the respective terminal with a separation gap. According to a further development, one or more of the apertures of the sealing plate are closed apertures that form a closed fluid reservoir around the respective terminal.

According to a further development, one or more of the apertures of the sealing plate open into an evacuation channel provided on the base.

According to a further development, the evacuation channel is located along an intersection edge of the base with the cover; and/or the cover includes one or more slots along said evacuation channel to expel the fluid condensate accumulated at the evacuation channel from the base.

According to a further development, the seal housing further comprises: a sealing compound provided at one or more discrete regions around one or more apertures of the base from which one or more electrical terminals protrude from the base to seal the junction between the electrical terminals and the base; wherein the size of the one or more discrete regions substantially coincide with the size of respective apertures provided in the sealing plate for passing the electrical terminals.

According to a further development, the sealing compound partially fills the separation gap between an aperture of the sealing plate and respective terminal so as to form a reservoir to collect fluid condensate diverted from the sealing plate.

According to a further development, the outwardly facing side of the base is provided with one or more recesses provided at matching locations below one or more apertures of the sealing plate, the one or more recesses being adapted to be filled with a sealing compound.

According to a further development, the electrical device is an electromagnetic relay.

The present invention also provides an electromagnetic relay as defined by appended claim 10.

The accompanying drawings are incorporated into and form a part of the specification for the purpose of explaining the principles of the invention. The drawings are not to be construed as limiting the invention to only the illustrated and described examples of how the invention can be made and used.

### BRIEF DESCRIPTION OF THE FIGURES

Further features and advantages will become apparent from the following and more detailed description of the invention as illustrated in the accompanying drawings, in which:
**Fig. 1** illustrates a sealed relay according to a prior art configuration;
**Fig. 2** is a perspective view of a sealed relay and a seal housing of the sealed relay according to an embodiment of the present invention, when viewed with the electrical terminals facing upwards;
**Fig. 3** is a perspective view of the sealed relay in an initial stage of assembly viewed from the electrical terminals side, when the base and cover are assembled together;
**Fig. 4** is a perspective view of the sealed relay in an intermediate stage of assembly, when a sealing compound is applied along intersection regions between the relay base, the relay cover and/or the relay electrical terminals;
**Fig. 5** is a perspective view of the relay in a final stage of assembly, when a sealing plate is mounted on top of the relay base;
**Fig. 6** is a top view of the sealed relay of Fig. 2 viewed from the relay base side;
**Fig. 7** is a cross-sectional view of the sealed relay according to a further embodiment; and
**Fig. 8** is a further perspective view of the sealed relay shown in Fig. 2, when viewed from the relay cover side.

### DETAILED DESCRIPTION OF THE INVENTION

The present invention will now be more fully described hereinafter with reference to the accompanying drawings, in which exemplary embodiments of the invention are shown. The present invention may, however, be embodied in many different forms and should not be construed as limited to the embodiments set forth herein. Rather, these embodiments are provided so that the disclosure will be thorough and complete, and will fully convey the scope of the invention to those skilled in the art. In particular, although certain features of the exemplary embodiments below will be described using terms such as "top", "bottom", "upper", "outward" and "inward", these terms are used for the sole purpose of facilitating the description of the respective features and their relative orientation and should not be construed as limiting the claimed invention or any of its components to a use in a particular spatial orientation. Like numbers refer to like elements throughout the description.

Fig. 2 is a perspective view of a sealed relay 200 using a seal housing 210 according to an embodiment of the present invention. In Fig. 2 the sealed relay 200 is depicted in a mounting orientation where the relay terminals 220, 224 are facing upwards. The seal housing 210 comprises a base 230 for mounting a relay assembly (not shown) on an inward side of the base 230 and a cover 240 for covering the relay assembly. For simplicity reasons, hereinafter the side of the relay base 230 facing to the inside of the housing 210 shall be referred to as the inwardly facing side and the side facing to the outside of the housing 210 as the outwardly facing side. The relay base 230 and the relay cover 240 are fitted together so as to form a closed chamber for accommodating the relay assembly components inside (not shown).

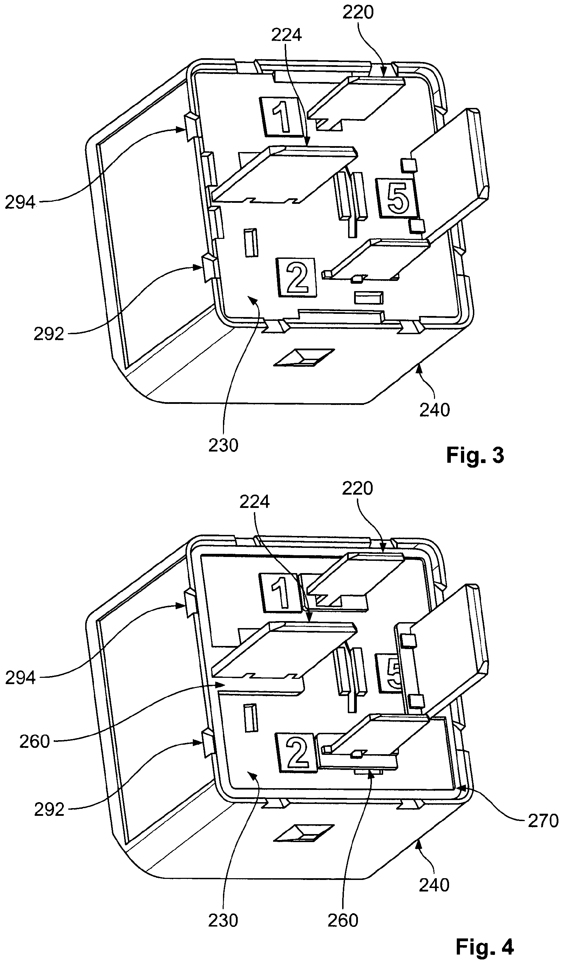

One or more apertures 250 are provided on the relay base 230 for passing one or more electric terminals 220, 224 to the outwardly facing side of the base 230 to couple the relay assembly to external electric circuits, as shown in Fig. 3. In order to prevent that dust, fluid or moisture penetrates into the housing 210 through the base apertures 250 for the electrical terminals 220, 224, the junction between each base aperture 250 and the respective terminal 220, 225 is sealed from the outside with a sealing compound 140, such as a glue, that is applied on a discrete region 260 around the aperture and respective terminal on the outwardly facing side of the relay base 230.

The fluid-tightness of the junction between the cover 240 and the relay base 230 may be improved by making the sidewalls of the cover 240 overlap the lateral sides of the relay base 230 and slightly pass beyond the outward surface of the relay base 230 so as to form an intersection edge on the outward side of the relay base 230 that can be sealed by applying a stripe 270 of sealing compound along the intersection edge. Fig. 4 shows an intermediate assembly stage of the sealed relay 200, after the relay assembly and relay base 230 are closed with the relay cover 240 and the sealing compound is applied in discrete patches 260 and stripes 270 around the relay terminals 220, 224 and along the intersection edge of the base 230, respectively.

Thus, in contrast with the conventional relay illustrated in Fig. 1, in which the sealing compound 140 is applied over the entire relay base 130, in the present invention the sealing compound 140 is applied only on discrete regions 260, 270 that circumvent intersection edges between the base 230 and the cover 240 and/or at the intersection between the electrical terminals 220, 224 and respective apertures 250 on the relay base 230.

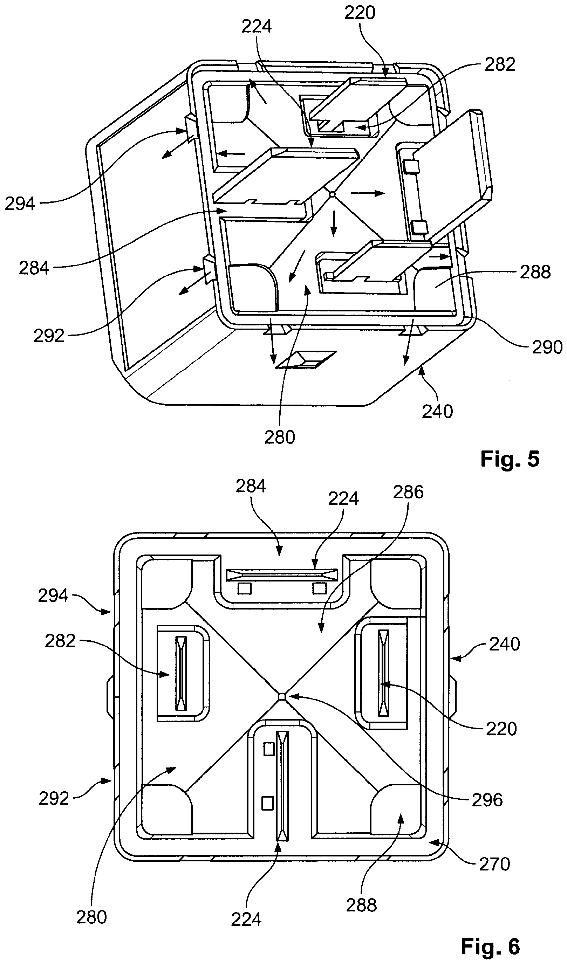

In order to further improve fluid-tightness of the housing base 230 and prevent the occurrence of short circuits due to dew condensation and/or fluids accumulated between the electric terminals 220, 224 that protrude outwards from the relay base 230, a sealing plate for partially covering the area of the relay base 230 and isolate the electrical terminals 220, 224 from each other may be provided, as it will now be described with reference to Fig. 5.

As shown in Fig. 5, the sealing plate 280 has a cut profile with one or more apertures 282, 284 for passing the electrical terminals 220, 224 protruding from the relay base 230. Each aperture 282, 284 of the sealing plate 280 is sized to allow a separation gap to the respective electrical terminal so that the sealing plate 280 does not enter in direct contact with the electrical terminals 220, 224. Preferably, the dimensions of the apertures 282, 284 are matched with the size of the discrete patches 260 of the sealing compound deposited around each electrical terminal 220, 224 protruding from the relay base 230 so that the sealing plate 280 and the sealing compound 260 closely contact with each other but without overlapping when the sealing plate 280 is arranged on top of the relay base 230. Accordingly, the edges of the sealing plate apertures 282, 284 also become sealed by the sealing compound patches 260, which avoids that liquids or moisture penetrate into the space between the sealing plate 280 and the relay base 230. Thus, since the sealing material is applied only at the intersection regions between the base 230, the cover 240 and/or the electrical terminals 220, 224 that are not covered by the sealing plate 280, the amount of sealing compound can be significantly reduced.

The thickness of the sealing plate 280, and in particular, at the edges of each of its apertures 282, 284 is preferably larger than the thickness of the sealing material deposited on the relay base 230 so that the sealing plate 280 also acts as a physical barrier that isolates the terminals 220, 224 protruding from the relay base 230 from each other, and therefore, prevents that short-circuit paths be established by the accumulation of moisture or dew condensation between the relay terminals 220, 224. Moreover, due to the difference in thickness between the sealing compound patches 260 and the edges of the sealing plate 280 around each electrical terminal 220, 224, a fluid reservoir with the width of the respective separation gap is formed around each of the electrical terminals 220, 224 that allows localizing any fluid or dew condensate that may be formed around the electrical terminals 220, 224 and/or diverted from the sealing plate 280, as it will be described later.

As shown in Fig. 5, one or more of the sealing plate apertures may be closed apertures 282 that completely isolate the respective electrical terminals 220 from neighbour terminals on the base 230. On the other hand, a number of the sealing plate apertures 284 may open into an evacuation channel 290 so as to allow evacuation of the fluid accumulated in the reservoirs 284 around the respective terminals 224. A mixed distribution of closed 282 and opened apertures 284 may be provided on the sealing plate 280 depending on the position and/or size of the electrical terminals 220, 224. For instance, opened 284 and closed reservoirs 282 may be alternated around the sealing plate 280 so as to isolate neighbouring terminals from each other and maximize the length of any connecting paths that could eventually be formed by fluid accumulated in the opened reservoirs via the evacuation channel 290. The opened apertures 284 may also be assigned to the largest relay terminals 224 and/or areas where a larger amount of dew condensation is likely to occur, while allowing that fluid accumulated in the opened apertures 284 to be expelled via the evacuation channel 290.

An example of an evacuation channel 290 that is provided around the base edges is shown in Fig. 5. The evacuation channel 290 is formed by dimensioning the sealing plate 280 so as to leave a distance to the side wall of the relay cover 240 when mounted on top of the relay base 230. As a result, an evacuation channel 290 with the width of the distance to the cover edge is formed around the perimeter of the underlying relay base 230. The evacuation channel 290 may receive and accumulate the moisture or dew condensation that is diverted from the sealing plate 280 towards the edges of the relay base 230, in particular when the sealed relay 200 is mounted in the upward direction, as well as from any of the reservoirs 284 around the electrical terminals 224 that open into the evacuation channel 290. The height of the evacuation channel 290 is approximately equal to the difference between the thickness of the sealing compound deposited around the relay base edge and the thickness of the sealing plate edge.

The evacuation of fluid accumulated in the evacuation channel 290 away from the relay base 230 may be facilitated by providing one or more cuts or slots 292 on the relay cover 240 along the evacuation channel 290. In the illustrated embodiment, the evacuation channel 290 at each of the lateral sides of the cover 240 has two slots 292, 294, placed closer to the cover corners where it is expected that a higher amount of fluid will be accumulated. However, the number of evacuation slots is not limited to the illustrated embodiment, and a larger or lower number of evacuation slots may be provided depending on the specific requirements. Further, although in the embodiment illustrated in Fig. 5 the evacuation channel 290 runs along the entire perimeter of the relay base 230, other configurations may be envisaged in which the evacuation channel 290 extends over only a portion of the relay base edge, for e.g. at areas where it is expected to accumulate more fluid.

In order to deviate the fluid or dew condensate formed at the sealing plate 280 away from the relay terminals 220, 224 and preferentially towards the fluid reservoirs 282, 284, and/or the evacuation channel 290 described above, the sealing plate 280 may be provided with an outward profile, i.e. on the outward side opposed to the side that faces the relay base 230, that is shaped with a non-flat profile designed to divert the fluid condensate accumulated on the sealing plate 280 along specific direction(s) and away from the electrical terminals 220, 224, irrespectively from the orientation with which the sealed relay 200 is mounted. For instance, the outward surface of the sealing plate 280 may have one or more faces 286 that are inclined with respect to the relay base 230. The inclined faces 286 divert the fluid or dew condensate that may form on the sealing plate 280 substantially along directions determined by the respective inclination angles and the orientation of the sealed relay 200.

Preferably, the outward surface of the sealing plate 280 comprises a plurality of inclined faces 286 having similar or different inclination angles with respect to the base 230, which ensures fluid diversion away from the relay terminals 220, 224 for every orientation of the sealed relay 200. For instance, in the configuration illustrated in Fig. 5 the outward surface comprises four inclined faces 286, each inclined face 286 having a triangular shape with respective apertures 282, 284 for passing the relay terminals 220, 224 and that is inclined with respect the relay base 230 by the same inclination angle α, resulting in an outward surface with a pyramidal shape. The dew condensate formed on each inclined face 286 will then be preferably diverted towards the evacuation channel 290 immediately opposed to the lower edge of respective inclined face 286, when the sealed relay 200 is mounted with the relay terminals 220, 224 facing upwards as in the orientation shown in Fig. 5. In case the sealed relay 200 is mounted with the relay terminals 220, 224 facing downwards, the fluid formed at the sealing plate 280 is diverted along the inclined faces 286 towards the center 296 of the sealing plate 280 and then simply falls from the sealing plate 280 by the effect of gravity.

Additional features 288 may be provided at each corner of the outward surface of the sealing plate 280 for facilitating the recollection of fluid condensate that descends along the respective inclined faces at the relay base 230 corners, in particular when the sealed relay 200 is mounted upwards. For instance, as illustrated in Fig. 5, flat depressions 288 may be provided at each corner of the sealing plate 280 where two adjacent inclined faces 286 are joined and substantially aligned with the evacuating slots 292, 294 of the relay cover 240 so as to accumulate the fluid descending along the inclined faces 286 at the corners of the sealing plate 280 and guide the fluid towards the evacuating slots 292, 294. Consequently, with this configuration, the fluid condensate is efficiently diverted by the non-flat profile of the sealing plate 280 towards the corners of the relay base 230 and from which it can be easily expelled.

A top view of the sealing plate 280 mounted on the relay base 230 is depicted in Fig. 6 for illustrating the arrangement of four triangular sections corresponding to the inclined faces 286 of the pyramidal shape shown in Fig. 5 and the respective flat depressions 288 at each corner of the sealing plate 280.

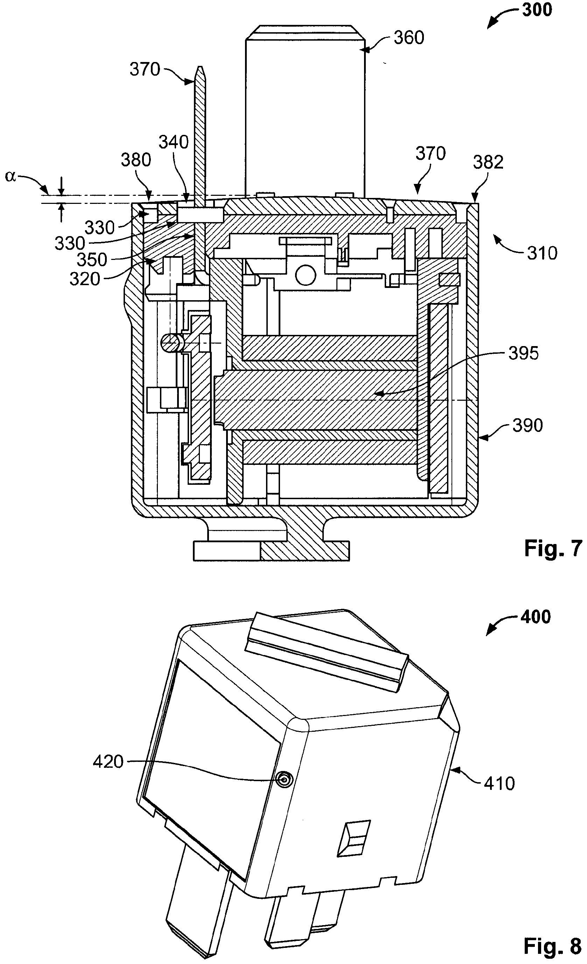

Fig. 7 shows a cross-sectional view of a sealed relay 300 and respective seal housing 310 according to a further embodiment of the present invention. The present embodiment essentially differs from the embodiment described with reference to Figs. 3 to 6 in that the relay base 320 includes one or more depressions 330 on the outwardly facing side to facilitate adhesion of the sealing compound 340 to as well as respective sealing effect is further improved by defining of the relay base 320 at the specific discrete regions where the sealing compound is to be applied.

For instance, as shown in Fig. 7, one or more recesses 330 may be provided that circumvent each of the relay base apertures 350 and the respective relay terminals 360 protruding from the relay base 320. These recesses 330 are preferably provided at matching locations below the apertures of the sealing plate 370.

Additionally, a stripe 380 of sealing compound may be selectively applied on a sealing groove 382 that is formed on the relay base 320 for this purpose along the intersection between the base 330 and the housing cover 390. As shown in Fig. 7, the sealing groove 382 may be formed by the lateral edge of the cover 390 that slightly extends above the outwardly facing side of the base 330 and a recess defined on the lateral side of the base 330 that contacts the cover 390.

The sealing recesses 330 and the sealing groove 382 serve as reservoirs for fixating the sealing compound 340 at selected discrete regions of the relay base 320 where the sealing effect is actually needed and so as to reduce the amount of sealing compound applied to the base 320. Moreover, these features allow to improve the adhesion of the sealing compound 340 to the base 320 in comparison to the case where the sealing compound is simply applied on top of the relay base around the electric terminals and/or at the intersection between the base and cover.

Fig. 8 is a perspective view of a sealed relay 400 viewed from a top side of the housing cover 410 and showing a nipp-off feature 420 to be closed after the sealing compound is cured to seal the relay completely.

Finally, although the present invention has been mainly described above with reference to seal housing for an relay and the respective sealed relay using the seal housing, the principles of the present invention can also be advantageously applied to other types of electrical and/or electronic devices which require an efficient protection of the respective electrical terminals against short-circuits caused by dew condensate and/or moisture accumulated at the outside surfaces of the electrical devices.

### Reference Signs

- 100: conventional sealed relay
- 110: housing
- 120: relay terminals
- 130: relay base
- 140: sealing glue

- 200: sealed relay
- 210: seal housing
- 220, 224: relay terminals
- 230: relay base (embodiment 1)
- 240: relay cover
- 250: base apertures for the electrical terminals
- 260: sealing compound around apertures
- 270: stripe of sealing compound along base edge
- 280: sealing plate
- 282: sealing plate closed apertures
- 284: sealing plate open apertures
- 286: inclined faces of sealing plate
- 288: flat depression in sealing plate
- α: inclination angle
- 290: evacuation channel
- 292, 294: slots in cover
- 296: center of sealing plate

- 300: sealed relay (embodiment 2)
- 310: seal housing
- 320: relay base
- 330: recesses of relay base
- 340: sealing compound
- 350: relay base apertures
- 360: electrical terminals
- 370: sealing plate
- 380: stripe of sealing compound
- 382: sealing groove along the base edge
- 390: housing cover
- 395: relay assembly

- 400: sealed relay
- 410: housing cover
- 420: nipp-off feature

## Claims

1. A seal housing for an electrical device, the electrical device having one or more protruding electrical terminals (220; 224; 360) for coupling to external electrical circuits, the seal housing comprising:
a base (230; 320) having one or more apertures (250; 350) adapted to pass one or more electrical terminals (220; 224; 360) from an inwardly facing side to an outwardly facing side of the base (230; 320); and
a cover (240; 390; 410) adapted to cover the inwardly facing side of the base (230; 320), thereby forming a housing for accommodating components of the electrical device (200; 300; 400);
**characterized by**
a sealing plate (280; 370) adapted to partially cover the outwardly facing side of the base (230; 320) and comprising one or more apertures (282, 284; 350) adapted to pass therethrough the one or more electrical terminals (220; 224; 360) protruding outwards from the base (230; 320);
wherein the sealing plate (280; 370) has a profile with a shape adapted to leave a separation gap between the sealing plate (280; 370) and an edge of the cover (240; 390; 410) surrounding the base so as to form, with the edge of the cover (240; 390; 410), an evacuation channel for collecting fluid condensate diverted from an outward side of the sealing plate (280; 370) towards the edge of the cover (240; 390; 410), and/or
wherein each of the one or more apertures (282, 284) of the sealing plate (280; 370) is sized with a width adapted to allow a respective separation gap to the electrical terminal (220; 224; 360) passing therethrough so that the sealing plate (280; 370) does not enter in direct contact with the one or more electrical terminals (220, 224) and with a thickness adapted to define a fluid reservoir around the respective electrical terminal (280; 370), when the sealing plate (280; 370) is mounted onto the outwardly facing side of the base (280; 370), for collecting fluid condensate formed at the outward side of the sealing plate (280; 370).

2. A seal housing according to claim 1, wherein
the shape of the sealing plate profile is adapted to divert fluid or fluid condensate formed at the outward side of the sealing plate (280; 370) by comprising one or more faces (286) that are inclined with respect to the outwardly facing side of the base (230; 320) by an inclination angle different from zero, wherein said inclination angle causes fluid condensate to descend along the one or more inclined faces (286).

3. A seal housing according to claim 2, wherein
the one or more inclined faces (286) are a plurality of inclined faces (286) that form a pyramidal shape.

4. A seal housing according to any one of the preceding claims, wherein
each of the one or more apertures (282, 284; 350) of the sealing plate (280; 370) surround a respective aperture of the one or more apertures (250, 350) in the base (230; 320) with a respective separation gap.

5. A seal housing according to claim 4, wherein
the one or more apertures (282) of the sealing plate (280) are through-holes (282),
wherein each through-hole forms a closed fluid reservoir around the respective aperture of the one or more apertures (250, 350) in the base (230; 320).

6. A seal housing according to any one of claims 1 to 5, wherein , in the alternatives of claim 1 defining an evacuation channel (290, 382), one or more of the one or more apertures (282) of the sealing plate (280) open into the evacuation channel (290, 382).

7. A seal housing according to any one of claims 1 to 6, wherein , in the alternatives of claim 1 defining an evacuation channel (290, 382), the evacuation channel (290, 382) is located along an intersection edge of the base (230 320) with the cover (240; 390); and/or the cover (240; 390) includes one or more slots (292, 294) along the evacuation channel to expel the fluid condensate accumulated at the evacuation channel from the base (230; 320).

8. A seal housing according to any one of the preceding claims, wherein
the outwardly facing side of the base (230; 320) is provided with one or more recesses provided at matching locations below one or more apertures of the one or more apertures (282, 284; 350) of the sealing plate (280; 370), the one or more recesses being adapted to be filled with a sealing compound.

9. A seal housing according to any one of the preceding claims, wherein
the housing formed by the base (230; 320) and the cover (240; 390) is adapted to accommodate inside components of an electromagnetic relay as said electrical device (200; 300; 400).

10. An electromagnetic relay, comprising:
a relay assembly;
one or more electrical terminals (220; 224; 360) coupled to the relay assembly; and
a seal housing (210; 310; 410) according to any one of the preceding claims for accommodating the relay assembly,
the base (230; 320) of the seal housing (210; 310; 410) being provided with the one or more apertures (250; 350) for passing the electrical terminals (220; 224; 360) to the outside of the seal housing (210; 310; 410).

11. An electromagnetic relay according to claim 10, further comprising:
a sealing compound (260; 340) provided at one or more discrete regions around the one or more apertures (250, 350) of the base (230; 320) from which the one or more electrical terminals (220; 224; 360) protrude from the base (230; 320) to seal the junction between the respective terminal of the one or more electrical terminals (220; 224; 360) and the base (230; 320);
wherein the size of the one or more discrete regions substantially coincide with the size of respective apertures of the one or more apertures (282, 284; 350) provided in the sealing plate (280; 370) for passing the one or more electrical terminals (220, 224; 360).

12. An electromagnetic relay according to claim 11, wherein
the sealing compound partially fills the separation gap between an aperture of the one or more apertures (282, 284, 350) of the sealing plate (280; 370) and respective terminal of the one or more electrical terminals (220, 224, 360) so as to form a reservoir to collect fluid condensate diverted from the sealing plate (280; 370).

## Patentansprüche

1. Dichtungsgehäuse für eine elektrische Vorrichtung, wobei die elektrische Vorrichtung einen oder mehrere vorstehenden/vorstehende elektrischen/elektrische Anschluss/Anschlüsse (220; 224; 360) zum Koppeln mit externen elektrischen Schaltungen aufweist und das Dichtungsgehäuse umfasst:
einen Sockel (230; 320) mit einer oder mehreren Öffnung/en (250; 350), die so eingerichtet ist/sind, dass sie einen oder mehrere elektrischen/elektrische Anschluss/Anschlüsse (220; 224; 360) von einer nach innen gewandten Seite zu einer nach außen gewandten Seite des Sockels (230; 320) durchlässt/durchlassen; sowie
eine Abdeckung (240; 390; 410), die so eingerichtet ist, dass sie die nach innen gewandte Seite des Sockels (230; 320) abdeckt und so ein Gehäuse zum Aufnehmen von Komponenten der elektrischen Vorrichtung (200; 300; 400) bildet;
**gekennzeichnet durch**
eine Dichtungsplatte (280; 370), die so eingerichtet ist, dass sie die nach außen gewandte Seite des Sockels (230; 320) teilweise abdeckt, und die eine oder mehrere Öffnung/en (282, 284; 350) aufweist, die so eingerichtet ist/sind, dass sie den einen oder die mehreren elektrischen Anschluss/Anschlüsse (220; 224; 360), der/die von dem Sockel (230; 320) nach außen vorsteht/vorstehen, durch diese hindurchlässt/hindurchlassen;
wobei die Dichtungsplatte (280; 370) ein Profil mit einer Form hat, die so eingerichtet ist, dass ein Trennungsspalt zwischen der Dichtungsplatte (280; 370) und einer Kante der Abdeckung (240; 390; 410) verbleibt, die den Sockel umgibt, so dass mit der Kante der Abdeckung (240; 390; 410) ein Ableitkanal zum Abführen von Flüssigkeitskondensat gebildet wird, das von einer Außenseite der Dichtungsplatte (280; 370) in Richtung der Kante der Abdeckung (240; 390; 410) abgeleitet wird, und/oder
wobei jede der einen oder mehreren Öffnung/en (282, 284) der Dichtungsplatte (280; 370) mit einer Breite, die so eingerichtet ist, dass ein entsprechender Trennungsspalt zu dem elektrischen Anschluss (220; 224; 360) so durch sie hindurch verlaufen kann, dass die Dichtungsplatte (280; 370) nicht in direkten Kontakt mit dem einen oder den mehreren elektrischen Anschluss/Anschlüssen (220, 224) kommt, sowie mit einer Dicke dimensioniert ist, die so eingerichtet ist, dass ein Flüssigkeits-Reservoir um den entsprechenden elektrischen Anschluss (280; 370) herum gebildet wird wenn die Dichtungsplatte (280; 370) an der nach außen gewandten Seite des Sockels (280; 370) angebracht ist, um an der Außenseite der Dichtungsplatte (280; 370) gebildetes Flüssigkeitskondensat zu sammeln.

2. Dichtungsgehäuse nach Anspruch 1, wobei
die Form des Profils der Dichtungsplatte so eingerichtet ist, dass an der Außenseite der Dichtungsplatte (280; 370) gebildete/s Flüssigkeit oder Flüssigkeitskondensat dadurch abgeleitet wird, dass es eine oder mehrere Fläche/n (286) umfasst, die in Bezug auf die nach außen gewandte Seite des Sockels (230; 320) um einen Neigungswinkel geneigt ist/sind, der sich von Null unterscheidet, wobei der Neigungswinkel bewirkt, dass Flüssigkeitskondensat entlang der einen oder mehreren geneigten Fläche/n (286) nach unten abfließt.

3. Dichtungsgehäuse nach Anspruch 2, wobei
die eine oder mehreren geneigte/n Fläche/n (286) eine Vielzahl geneigter Flächen (286) ist/sind, die eine Pyramidenform bilden.

4. Dichtungsgehäuse nach einem der vorangehenden Ansprüche, wobei
jede der einen oder mehreren Öffnung/en (282, 284; 350) der Dichtungsplatte (280; 370) eine entsprechende Öffnung der einen oder mehreren Öffnung/en (250, 350) in dem Sockel (230; 320) mit einem entsprechenden Trennungsspalt umgibt.

5. Dichtungsgehäuse nach Anspruch 4, wobei
eine oder mehrere der Öffnungen (282) der Dichtungsplatte (280) ein Durchgangsloch/Durchgangslöcher (282) ist/sind, wobei jedes Durchgangsloch ein geschlossenes Flüssigkeits-Reservoir um die entsprechende Öffnung der einen oder mehreren Öffnung/en (250, 350) in dem Sockel (230; 320) bildet.

6. Dichtungsgehäuse nach einem der Ansprüche 1 bis 5, wobei es in den Alternativen von Anspruch 1 einen Abführungskanal (290, 382) aufweist,
eine oder mehrere der einen oder mehreren Öffnung/en (282) der Dichtungsplatte (280) sich in den Abführungskanal (290, 382) hinein öffnet/öffnen.

7. Dichtungsgehäuse nach einem der Ansprüche 1 bis 6, wobei es in den Alternativen von Anspruch 1 einen Abführungskanal (290, 382) aufweist,
der Abführungskanal (290, 382) entlang einer Schnittkante des Sockels (230; 320) mit der Abdeckung (240; 390) angeordnet ist; und/oder
die Abdeckung (240; 390) einen oder mehrere Schlitz/e (292, 294) entlang des Abführungskanals aufweist, um das in dem Abführungskanal angesammelte Flüssigkeitskondensat aus dem Sockel (230; 320) auszustoßen.

8. Dichtungsgehäuse nach einem der vorangehenden Ansprüche, wobei
die nach außen gewandte Seite des Sockels (230; 320) mit einer oder mehreren Aussparung/en versehen ist, die an passenden Stellen unterhalb einer oder mehrerer Öffnung/en der einen oder mehreren Öffnung/en (282, 284; 350) der Dichtungsplatte (280; 370) vorhanden ist/sind, wobei die eine oder mehreren Aussparung/en zum Füllen mit einer Dichtungsmasse eingerichtet ist/sind.

9. Dichtungsgehäuse nach einem der vorangehenden Ansprüche, wobei
das durch den Sockel (230; 320) und die Abdeckung (240; 390) gebildete Gehäuse so eingerichtet ist, dass es im Inneren Komponenten eines elektromagnetischen Relais als der elektrischen Vorrichtung (200; 300; 400) aufnimmt.

10. Elektromagnetisches Relais, das umfasst:
eine Relais-Baugruppe;
einen oder mehrere elektrischen/elektrische Anschluss/Anschlüsse (220; 224; 360), der/die mit der Relais-Baugruppe verbunden ist/sind; und
ein Dichtungsgehäuse (210; 310; 410) nach einem der vorangehenden Ansprüche zum Aufnehmen der Relais-Baugruppe,
den Sockel (230; 320) des Dichtungsgehäuses (210; 310; 410), der mit der einen oder den mehreren Öffnung/en (250; 350) zum Durchlassen der elektrischen Anschlüsse (220; 224; 360) zu der Außenseite des Dichtungsgehäuses (210; 310; 410) versehen ist.

11. Elektromagnetisches Relais nach Anspruch 10, das des Weiteren umfasst:
eine Dichtungsmasse (260; 340), die in einem oder mehreren separaten Bereich/en um die eine oder mehreren Öffnung/en (250, 350) des Sockels (230; 320) herum vorhanden ist, über die der eine oder die mehreren elektrische/elektrischen Anschluss/Anschlüsse (220; 224; 360) von dem Sockel (230; 320) vorsteht/vorstehen, um die Verbindung zwischen dem entsprechenden Anschluss des einen oder der mehreren elektrischen Anschlusses/Anschlüsse (220; 224; 360) und dem Sockel (230; 320) abzudichten;
wobei die Größe des einen oder der mehreren separaten Bereiches/Bereiche im Wesentlichen mit der Größe der entsprechenden Öffnungen der einen oder mehreren Öffnung/en (282, 284; 350) übereinstimmt, die in der Dichtungsplatte (280; 370) zum Durchlassen des einen oder der mehreren elektrischen Anschlusses/Anschlüsse (220, 224; 360) vorhanden ist/sind.

12. Elektromagnetisches Relais nach Anspruch 11, wobei
die Dichtungsmasse den Trennungsspalt zwischen einer Öffnung der einen oder mehreren Öffnung/en (282, 284, 350) der Dichtungsplatte (280; 370) und dem entsprechenden Anschluss des einen oder der mehreren elektrischen Anschlusses/Anschlüsse (220, 224, 360) teilweise füllt, um ein Reservoir zum Sammeln von der Dichtungsplatte (280; 370) abgeleitetem Flüssigkeitskondensat zu bilden.

## Revendications

1. Boîtier d'étanchéité pour un dispositif électrique, le dispositif électrique possédant une ou plusieurs bornes électriques (220 ; 224 ; 360) en saillie permettant un couplage avec des circuits électriques externes, le boîtier d'étanchéité comprenant :
une base (230 ; 320) comportant une ou plusieurs ouvertures (250 ; 350) conçues pour faire passer une ou plusieurs bornes électriques (220 ; 224 ; 360) d'un côté faisant face vers l'intérieur à un côté faisant face vers l'extérieur de la base (230 ; 320), et
un couvercle (240 ; 390 ; 410) conçu pour recouvrir le côté faisant face vers l'intérieur de la base (230 ; 320) en formant ainsi un boîtier permettant d'accueillir des composants du dispositif électrique (200 ; 300 ; 400),
**caractérisé par :**
une plaque d'étanchéité (280, 370) conçue pour recouvrir partiellement le côté faisant face vers l'extérieur de la base (230 ; 320) et comprenant une ou plusieurs ouvertures (282, 284 ; 350) conçues pour faire passer à travers elles la ou les bornes électriques (220 ; 224 ; 360) en saillie vers l'extérieur depuis la base (230 ; 320),
dans lequel la plaque d'étanchéité (280, 370) présente un profil de forme adaptée pour laisser un intervalle de séparation entre la plaque d'étanchéité (280, 370) et un bord du couvercle (240 ; 390 ; 410) entourant la base de sorte à former, avec le bord du couvercle (240 ; 390 ; 410), un canal d'évacuation permettant de recueillir un condensat de fluide détourné du côté externe de la plaque d'étanchéité (280, 370) en direction du bord du couvercle (240 ; 390 ; 410), et/ou
dans lequel chacune de la ou des ouvertures (282, 284) de la plaque d'étanchéité (280, 370) présente une largeur conçue pour autoriser un intervalle de séparation respectif avec la borne électrique (220 ; 224 ; 360) le traversant de sorte à ce que la plaque d'étanchéité (280, 370) n'entre pas en contact direct avec la ou les bornes électriques (220 ; 224), et une épaisseur conçue pour définir un réservoir de fluide autour de la borne électrique (280 ; 370) respective lorsque la plaque d'étanchéité (280, 370) est montée sur le côté faisant face vers l'extérieur de la base (230 ; 320) afin de recueillir le condensat de fluide formé à l'extérieur de la plaque d'étanchéité (280, 370).

2. Boîtier d'étanchéité selon la revendication 1, dans lequel :
la forme du profil de la plaque d'étanchéité est conçue pour détourner un fluide ou un condensat de fluide formé à l'extérieur de la plaque d'étanchéité (280, 370), car il comprend une ou plusieurs faces (286) qui sont inclinées par rapport au côté faisant face vers l'extérieur de la base (230 ; 320) d'un angle d'inclinaison différent de zéro, ledit angle d'inclinaison amenant le condensat de fluide à descendre le long de la ou des faces inclinées (286).

3. Boîtier d'étanchéité selon la revendication 2, dans lequel :
la ou les faces inclinées (286) sont une pluralité de faces inclinées (286) qui prennent une forme pyramidale.

4. Boîtier d'étanchéité selon l'une quelconque des revendications précédentes, dans lequel :
chacune de la ou des ouvertures (282, 284 ; 350) de la plaque d'étanchéité (280, 370) entoure une ouverture respective parmi la ou les ouvertures (250 ; 350) dans la base (230 ; 320) en ménageant un intervalle de séparation respectif.

5. Boîtier d'étanchéité selon la revendication 4, dans lequel :
la ou les ouvertures (282) de la plaque d'étanchéité (280) sont des trous traversant (282),
chaque trou traversant formant un réservoir fermé de fluide autour de l'ouverture respective parmi la ou les ouvertures (250 ; 350) dans la base (230 ; 320).

6. Boîtier d'étanchéité selon l'une quelconque des revendications 1 à 5, dans lequel :
dans les variantes de la revendication 1 définissant un canal d'évacuation (290, 382), une ou plusieurs parmi la ou les ouvertures (282) de la plaque d'étanchéité (280) s'ouvrent dans le canal d'évacuation (290, 382).

7. Boîtier d'étanchéité selon l'une quelconque des revendications 1 à 6, dans lequel :
dans les variantes de la revendication 1 définissant un canal d'évacuation (290, 382), le canal d'évacuation (290, 382) est situé le long d'une bordure d'intersection de la base (230 ; 320) avec le couvercle (240 ; 390), et/ou
le couvercle (240 ; 390) inclut une ou plusieurs gorges (292, 294) le long du canal d'évacuation dans le but d'expulser le condensat de fluide accumulé au niveau du canal d'évacuation depuis la base (230 ; 320).

8. Boîtier d'étanchéité selon l'une quelconque des revendications précédentes, dans lequel :
le côté faisant face vers l'extérieur de la base (230 ; 320) est doté d'un ou plusieurs évidements ménagés à des emplacements correspondants situés en dessous de la ou des ouvertures parmi la ou les ouvertures (282, 284 ; 350) de la plaque d'étanchéité (280, 370), le ou les évidements étant conçus pour être remplis d'un composé d'étanchéité.

9. Boîtier d'étanchéité selon l'une quelconque des revendications précédentes, dans lequel :
le boîtier formé par la base (230 ; 320) et le couvercle (240 ; 390) est adapté pour accueillir des composants internes d'un relais électromagnétique en tant que dit dispositif électrique (200 ; 300 ; 400).

10. Relais électromagnétique comprenant :
un ensemble relais,
une ou plusieurs bornes électriques (220 ; 224 ; 360) couplées à l'ensemble relais, et
un boîtier d'étanchéité (210 ; 310 ; 410) conforme à l'une quelconque des revendications précédentes, destiné à accueillir l'ensemble relais,
la base (230 ; 320) du boîtier d'étanchéité (210 ; 310 ; 410) étant munie de la ou des ouvertures (250 ; 350) permettant de faire passer les bornes électriques (220 ; 224 ; 360) à l'extérieur du boîtier d'étanchéité (210 ; 310 ; 410) .

11. Relais électromagnétique selon la revendication 10, comprenant en outre :
un composé d'étanchéité (260 ; 340) disposé au niveau d'une ou plusieurs zones discrètes autour de la ou des ouvertures (250 ; 350) de la base (230 ; 320) à partir de laquelle la ou les bornes électriques (220 ; 224 ; 360) dépassent de la base (230 ; 320), dans le but de rendre étanche la jonction entre la borne respective parmi la ou les bornes électriques (220 ; 224 ; 360) et la base (230 ; 320),
dans lequel la taille de la ou des zones discrètes coïncide pratiquement avec la taille des ouvertures respectives parmi la ou les ouvertures (282, 284 ; 350) ménagées dans la plaque d'étanchéité (280, 370) pour faire passer la ou les bornes électriques (220 ; 224 ; 360).

12. Relais électromagnétique selon la revendication 11, dans lequel :
le composé d'étanchéité remplit partiellement l'intervalle de séparation entre une ouverture parmi la ou les ouvertures (282, 284 ; 350) de la plaque d'étanchéité (280, 370) et une borne respective parmi la ou les bornes électriques (220 ; 224 ; 360) de sorte à former un réservoir destiné à recueillir un condensat de fluide détourné de la plaque d'étanchéité (280, 370).
